# EUROPEAN PATENT APPLICATION

(11) **EP 4 847 256 A1**
(43) Date of publication of application: **02.12.2026**
(21) Application number: 25178882.4
(22) Date of filing: 26.05.2025
(51) Int. Cl.: B41J 2/045, B41J 2/14, H05K 3/00, H05K 1/00

(54) **IMPULSE PRINTING DEVICE AND IN-SITU MONITORING METHOD**

(71) Applicant: FononTech Holding B.V., 5656 AE Eindhoven (NL)
(72) Inventor: KOLDEWEIJ, Robin Bernardus Johannes, 5656 AE Eindhoven (NL); FIJN, Joost, 5656 AE Eindhoven (NL); SCHRAM, Jeroen Franciscus Marinus, 5656 AE Eindhoven (NL)
(74) Representative: V.O.

(57) **Abstract**

Disclosed is an impulse printing device and corresponding method for in-situ monitoring a health status of at least one resistive heater element of the device. The impulse printing device is arranged for performing a print cycle and a monitoring cycle. In the monitoring cycle, the resistive heater element is controlled with a low voltage monitoring pulse and the actual resistance of the resistive heater element is determined based on the measure voltage and current. In case the actual resistance deviates from a reference by a least a delta, an alert signal is generated to indicate that the at least one resistive heater element is faulty.

## Description

The invention relates to an impulse printing device for printing a substance onto an acceptor substrate. The invention further relates to a method, performed by the impulse printing device, for in-situ monitoring a health status of at least one resistive heater element of the impulse printing device.

### BACKGROUND

Impulse printing uses rapid electrical heater elements to transfer ink patterns from a donor plate onto an acceptor substrate, e.g. as disclosed in EP4037442. The rapid heating process potentially induces severe thermal stresses on the heater elements. This can lead to cracks in the heater elements, diminishing their functionality. When a broken heater element is used in heating, potentially a plasma is created in the crack which further damages the heater element.

For this reason, heater elements of an impulse printing device may need to be checked and serviced at regular intervals, or even replaced as a precaution, to guarantee proper functioning of the impulse printing device. This can be a time consuming and costly process. Conventional monitoring methods e.g. involve the use of external measurement devices to analyze the performance of one or more heater elements Optical measurements can be performed by installing cameras and scanning each element individually, so that potential damage in the heater elements can be found optically, or by means of detecting bright light flashes caused by plasma generation in a crack. However, it can be complicated to optically measure small length scale features, e.g. in the order of 0.1-100 micrometer, on relatively large surfaces if the damage is not known a priori.

Alternatively, in acoustic measurement methods, 'cracking' noises caused by the generation of plasma in a crack can be picked up by a microphone to detect the presence of a faulty resistive heater element. However, this means that the environment needs to be sufficiently controlled, e.g. silent, for the noise to be measured. Beyond that, determining the exact location of the source of the noise can be cumbersome.

Other known measurement methods are based on detection of electrical response of the heater elements, e.g. by measuring a break-through voltage to a secondary component. For example, when a metal plate is moved close to a broken heater element, electrical break-through may occur. This can however introduce a risk of damaging other components close to the heater elements due to arcing or mechanical interaction.

In these known methods, the use of specific measurement equipment adds to the cost and complexity of the system, and the measurements themselves may increase the downtime of the system.

Furthermore, conventional monitoring methods may not be able to accurately detect and pinpoint a crack. Due to the progressive nature of crack propagation in heater elements, a crack is preferably detected as soon as possible to prevent larger quality and reliability issues later on. Ideally, the functionality of the heater elements is checked before each printing step, however this may not be practical with the conventional monitoring methods.

### SUMMARY

The present invention aims to solve the problem mentioned above, by providing an improved impulse printing device, as well as an improved monitoring method that facilitates early detection of damage to heater elements, and allows to do so in a cost effective way.

For this purpose, aspects of the invention provide an impulse printing device as defined in the appended claims. The impulse printing device comprises a donor plate onto which a substance to be printed can be applied, at least one resistive heater element arranged for heating the applied substance at its contact surface with the donor plate, and a control unit. The control unit is arranged for controlling, in a print cycle, the at least one resistive heater element with a high voltage printing pulse for rapidly evaporating a part of the substance at its contact surface, for therewith inducing a pressure that causes a transfer of a remainder of the patterned substance in a transfer direction towards an acceptor substrate.

In accordance with the invention, the control unit is further arranged for monitoring a health status of the at least one heater element by controlling the at least one resistive heater element with a low voltage monitoring pulse, determining an actual resistance of the at least one resistive heater element based on a measured voltage and current through the at least one resistive heater element, comparing the actual resistance to a reference and, in response to determining that the actual resistance deviates from the reference by at least a delta, generating an alert signal that is indicative of the at least one resistive heater element being faulty, e.g. comprises a crack.

Accordingly, the impulse printing device is able to perform in-situ monitoring of its resistive heater elements, preferably on a single element level, to detect damaged heater element(s) at an early stage. For example, the control unit may be arranged to monitor the health status of the at least one resistive heater element between successive print cycles, at specific time intervals, or after a certain number of print cycles have been performed.

The alert signal can e.g. be used to notify an operator that service is needed. Alternatively, or additionally, the control unit may be arranged to shut down the faulty heater element, or to shut down the impulse printing device completely in response to the alert signal, or the alert signal itself may cause a (partial) shut down of the impulse printing device.

Preferably, the electric circuit that is used for supplying the high voltage printing pulse in the print cycle(s) is also used for supplying the low voltage monitoring pulse. In other words, no external devices or hardware modifications to the impulse printing device may be needed.

Making use of the same electric circuit for two functions, i.e. both printing and monitoring, is not encountered in the field of impulse printing. Heating array solutions in other fields are designed for relatively much lower power and longer pulse times, compared to resistive heater elements as used for impulse printing. The latter require a different approach of determining the health status of the heater elements, since other types of failures can occur. For example, cracks and arcing on the heater element are less likely to occur in non-impulse printing heater solutions.

In the present invention, the health status of the at least one resistive heater element is determined by the control unit supplying a distinct, low voltage monitoring pulse to the at least one resistive heater element, and measuring the electric response. By integrating the monitoring method in the impulse printing device, a reliable and cost-effective solution is obtained.

The low voltage monitoring pulse preferably has monitoring voltage that is non-arcing, e.g. does not generate a plasma, when the at least one resistive heater element has a crack with a certain crack size. For this reason, the monitoring voltage is preferably relatively low compared to the printing voltage of the high voltage printing pulse. For example, the monitoring voltage is equal to or less than 100 Volt, preferably between 10 and 60 Volt. The printing voltage, in turn, is typically significantly higher than 100 Volt. Nevertheless, in some applications the heater element may be configured to perform printing below 100 Volt as well. In any case, the monitoring voltage is preferably as low as possible, preferably at least substantially lower than the printing voltage, to prevent plasma generation in case of a crack.

Preferably, the low voltage monitoring pulse comprises a monitoring pulse time that is equal to or longer than the printing pulse time of the high voltage printing pulse. For example, the monitoring pulse time is at least a factor 10, preferably at least a factor 100, longer than the printing pulse time. The longer pulse time allows for a further reduction of the monitoring voltage, thereby lowering the risk of further damaging the at least one heater element. Also, the relatively long monitoring pulse time allows for better detection of cracks in the at least one heater element. However, the main reason for having a longer pulse time is that the noise to signal ratio is reduced. Notwithstanding, the monitoring pulse time is still preferably shorter than 10 milliseconds, to minimize the time period or delay caused by the health status check when performed between successive print cycles.

Although the present invention is not intended to be limited thereto, the monitoring voltage of the low voltage monitoring pulse is preferably substantially constant over the monitoring pulse time. In that case the actual resistance of the at least one monitored resistive heater element can be compared to both the reference as well as a resistance of the same resistive heater element that is measured during the printing cycle. Both measurements during the health status monitoring and during the print cycle can be performed by the same control unit, and preferably also with the same electric circuit.

Alternatively, for monitoring the health status, any random or predefined monitoring voltage signal can be used, as long as it does not lead to plasma generation in case a crack is present. Therefore, the monitoring voltage is preferable kept below 100 Volt, more preferably below 60 Volt, at all times. From the monitoring voltage signal, the impedance, and with that the resonance and resistance, of the at least one resistive heater element can be determined.

A third option is to use a monitoring voltage signal for a significantly longer time than the pulse time to improve the signal to noise level, enabling detection of cracks with better accuracy.

In preferred embodiments, when the at least one resistive heater element is part of an array of multiple resistive heater elements, the control unit may be arranged for monitoring the health status for each resistive heater element of the array on a single element level. In other words, each resistive heater element can be individually monitored, by supplying the low voltage monitoring pulse to said individual resistive heater element, and measuring its electric response. The electric circuit that is used for supplying the high voltage printing pulse to each resistive heater element individually can also be used for supplying the low voltage monitoring pulse on the single element basis.

The control unit can be arranged for monitoring the health status of the at least one resistive heater element between consecutive print cycles of the impulse printing device, to ensure that the at least one resistive heater element is functioning properly before starting a new print cycle. The health status may be monitored between each pair of consecutive print cycles, or between sets of print cycles. For example, the health status is checked after the completion of a set of two, three, four, or more print cycles. Alternatively, or additionally, the control unit may be arranged for monitoring the health status of the at least one resistive heater element after a certain time period has passed. For example, when the impulse printing device has been printing for a given time period, e.g. five minutes or any other desired time period, the control unit performs a health status check. The health status is preferably monitored at regular intervals, e.g. in terms of printing cycles or time, without the invention being limited to regular health status checks.

The control unit may be configured to increase and decrease the monitoring frequency based on the power consumption of the impulse printing device. For example, when a relatively high voltage is supplied to the at least one resistive heater element during one or more printing cycles, the risk of crack formation in one of the heater elements may be increased, and the control unit may in such cases monitor the health status of the at least one resistive heater element more frequently. Similarly, the risk of crack formation in one of the heater elements may be increased when a relatively large number of resistive heater element is involved in one or more print cycles, in that using more heaters increases the statistical chance of failure, and the control unit may accordingly increase the frequency of monitoring the health status. In further variants, since some resistive heater elements may be used for printing more frequently or more intensely than others, the control unit may be arranged for monitoring the health status of one or more first resistive heater elements with a first frequency, and for monitoring one or more second resistive heater elements with a second frequency.

Preferably, the control unit is arranged for controlling the at least one resistive heater element with the low voltage monitoring pulse in a startup phase of the impulse printing device prior to an initial print cycle, and for storing the determined actual resistance of the at least one resistive heater element as a baseline of the reference. The startup phase e.g. occurs between a time when the impulse printing device is switched on from an unpowered state, or reactivated after a pause, and a time when the initial print cycle starts. An initial health status check of the at least one resistive heater element may be performed in this startup phase, and the corresponding resistance of the at least one resistive heater element can be used as the reference for further measurements.

Alternatively, the reference can be an expected reference, e.g. based on earlier measurements, a value from a database, or an average resistance of multiple resistive heater elements of the impulse printing device.

To account for variations in the resistance of the at least one resistive heater element over time, e.g. due to changes in environment conditions, process conditions, and other normal use related effects, the control unit may be arranged for logging the determined actual resistance over time, and for calculating the reference based on a weighted average of the most recently determined actual resistance and an historic or fitted value of one or more older logged references. For example, the reference may be determined by calculating a running average of actual resistance values logged over a certain time period, a root-mean-square, or any other derived value. Historic values can e.g. be obtained from a database, e.g. external or integrated in the device, and/or from measurements performed with the impulse printing device. Different weights may be given to historic value, logged values, and actual values, to adjust the sensitivity of the health status check.

The delta is preferably between 1%-5% of the reference. A delta smaller than 1% may increase the number of false positive alert signals, while a delta larger than 5% may generate too many false negative alert signals. Additionally, cracks that produce an alert signal with a delta larger than 5% of the reference might be through the complete heater element.

In some embodiments, the at least one resistive heater element comprises a first resistive heater element and a second resistive heater element, and the control unit is arranged for determining a first actual resistance of the first resistive heater element and a second actual resistance of the second resistive heater element. In other words, an actual resistance of each individual resistive heater element is determined. In that case, the control unit can be further arranged for comparing the first actual resistance to the second actual resistance, and for generating an alert signal in response to determining that the first and second actual resistances deviate from each other by at least a further threshold. The further threshold can for example be between 3-5% of the first or second actual resistance. Thus, the actual resistances of individual resistive heater elements are compared to each other, to detect differences between resistive heater elements. This can be done in addition to comparing the actual resistance of each individual resistive heater element to the reference as described herein. The benefit of this is that in case of an array of resistive heater elements, a relatively uniform quality, or homogenous performance, across the array can be ensured. The control unit can for example be arranged for calculating a first moving average of the first actual resistance over a time period, and for calculating a second moving average of the second actual resistance of the time period. Accordingly, the control unit may further be arranged for comparing the first moving average to the second moving average, and for generating an alert signal in response to determining that the first and second moving averages deviate from each other by at least the further threshold.

Other aspects of the invention provide a method as defined in the appended claims, performed by the impulse printing device described herein for in-situ monitoring a health status of at least one resistive heater element of the impulse printing device. The method comprises, in any order and as part of any sequence, a step of performing a print cycle and a step of performing a monitoring cycle.

The step of performing a print cycle can be executed by controlling, in particular by the control unit of the impulse printing device, the at least one resistive heater element with a printing pulse for rapidly evaporating a part of the substance at its contact surface, for therewith inducing a pressure that causes a transfer of a remainder of the patterned substance in a transfer direction towards an acceptor substrate.

The monitoring cycle can be performed by (i) controlling the at least one resistive heater element with a low voltage monitoring pulse; (ii) determining an actual resistance of the at least one resistive heater element based on a measured voltage and current through the at least one resistive heater element; (iii) comparing the actual resistance to a reference; and (iv) generating an alert signal that is indicative of a faulty resistive heater element in response to determining that the actual resistance deviates from the reference by at least a delta.

### BRIEF DESCRIPTION OF THE DRAWINGS

The invention will be further elucidated in the figures:
FIG. 1 illustrates an embodiment of an impulse printing device in accordance with the present invention, with one or more resistive heater elements;
FIG. 2 provides a detailed illustration of multiple resistive heater elements in a resistive heater layer, in one embodiment of the present invention;
FIG. 3 represents an embodiment of a method for in-situ monitoring of a health status of resistive heater elements;
FIG. 4 provides a number of graphs comparing the measured output of a faulty resistive heater element to a reference.

### DETAILED DESCRIPTION

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

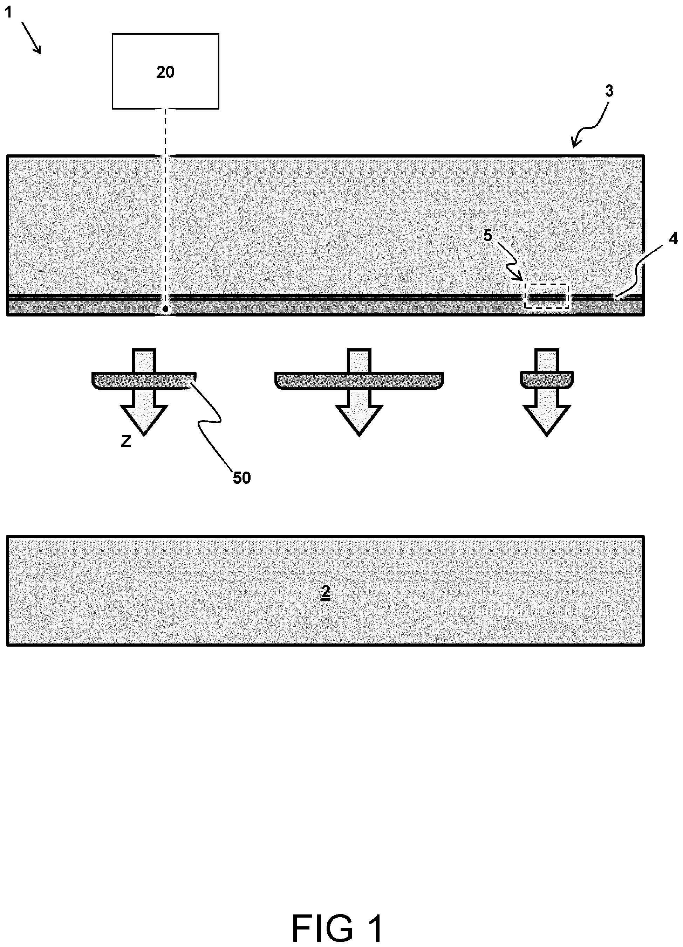

FIG. 1 illustrates an embodiment of a printing device 1 for printing a substance 50, e.g. comprising a functional material, onto an acceptor substrate 2. The substance may further comprise a carrier, e.g. a solvent or liquid, to carry the functional material. The formulation is often referred to as an ink or paste, depending on the viscosity. Examples thereof are a conductive adhesive comprising a thermal or UV settable resin loaded with silver particles, or a solder paste comprising solder particles and flux. Alternatively the functional material may be of a non-conductive nature so as to provide an insulating element on the target surface.

The printing device 1 comprises a donor plate 3 onto which the substance is to be applied in a pattern to be printed, e.g. using a stencil plate and a squeegee.

A heater facility 4, comprising at least one resistive heater element 5, is arranged for heating the applied substance 50 at its contact surface with the donor plate 3. The heater facility 4 may be embedded in, or an integral part of the donor plate 3. Preferably, the heater facility comprises a layer of multiple resistive heater elements 5, as illustrated in FIG. 1. In such case, the resistive heater elements 5 are arranged in an array, for heating respective zones of the donor plate 3. In this way, zones of the donor plate 3 can be heated independently. The heating elements 5 preferably have a temperature dependent resistance.

The printing device 1 further comprises a control unit 20 that is arranged for controlling the heater facility 4. In a print cycle, the control unit 20 controls one or more resistive heater elements 5 of the heater facility with a high voltage printing pulse for rapidly evaporating a part of the substance 50 at its contact surface. As a result, a pressure is induced that rapidly evaporates a part of the substance, e.g. the carrier, and causes a transfer of a remainder of the patterned substance towards and onto the acceptor substrate 2, e.g. in a transfer direction Z.

The high voltage printing pulse may involve a printing voltage that is usually substantially higher than 100 Volts, but can also be lower in some applications. The printing voltage is supplied to the resistive heater element 5 within a printing pulse time of less than 100 microseconds. Due to this high energy density in combination with the resistance of the heater element 5, a current is generated that causes a rapid and large increase in temperature of the heater element. After this, the resistive heater element 5 cools down again. Due to the relatively large electric and thermal load during such an 'impulse printing' cycle, the resistive heater element 5 may be susceptible to crack formation.

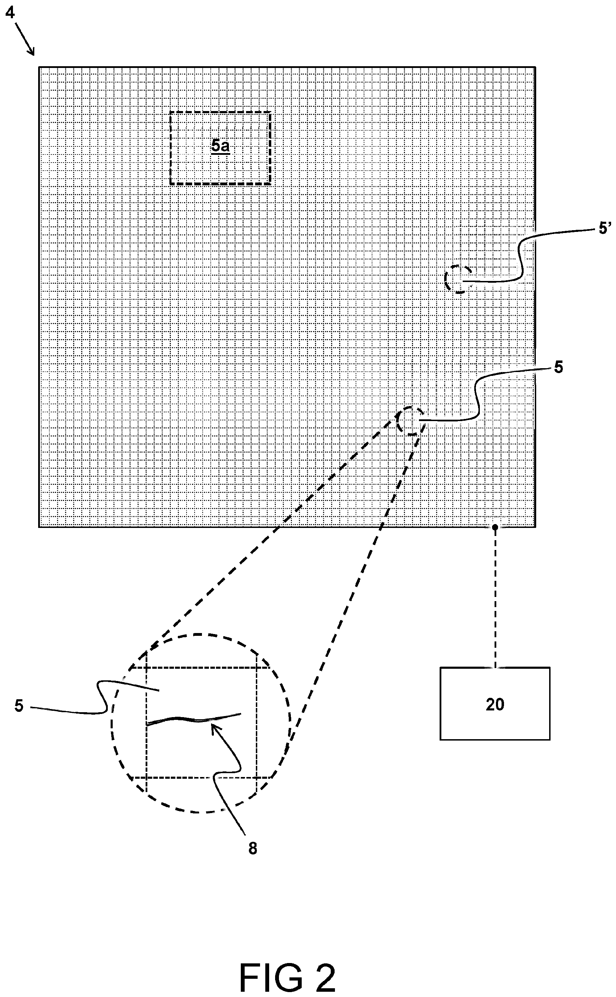

FIG. 2 provides a detailed view of an embodiment of the heater facility 4, comprising multiple resistive heater elements 5 in an array. Once a crack 8 is formed in one of the resistive heater elements 5, the resistance of that heater element 5 is locally affected, and any further printing pulse that is directed through the resistive heater element 5 may further damage the heater element, and may potentially also damage neighboring heater elements or other components of the impulse printing device. For example, due to the relatively high voltage a plasma may be generated across the width of the crack 8.

To monitor the health status of the resistive heater element 5, i.e. to detect whether the heater element is intact and functioning as expected, the control unit 20 is arranged for performing a monitoring cycle. In the monitoring cycle, the control unit supplies a low voltage monitoring pulse to the resistive heater element 5. The monitoring cycle can be performed before or after performing the print cycle, preferably between successive print cycles. Accordingly the quality, or health status, of the resistive heater element(s) 5 can be checked before and after each print cycle. In this way, defects, faults and unexpected wear of the resistive heater element(s) are detected at an early stage, avoiding plasma generation.

In case of multiple resistive heater elements 5, e.g. each being part of a heater array as shown in FIG. 2, the control unit 20 may be arranged for individually monitoring the health status of each resistive heater element 5 of the array, thus on a single element level. Each resistive heater element 5 may be associated with a unique identifier, and/or a specific location within the array, so that a faulty resistive heater element can be individually detected and pinpointed. In this way, defective heater elements can be serviced, replaced, or shut down during subsequent print cycles.

Alternatively, or additionally, the control unit 20 may be arranged to perform a health status check on multiple resistive heater elements as a set 5a. Such a set 5s e.g. comprises a number of neighboring heater elements 5, or a number of heater elements 5 that together form a subset of the heater array 4. Monitoring multiple heater elements as a set 5a can already provide a relatively course indication of the performance of the heater array 4 which in some applications can speed up the monitoring process. For example, in case it is not possible or practical to service the resistive heater elements 5 on an individual level, monitoring on the basis of heater element sets 5a or modules may provide an alternative solution. Optionally, in case a fault is detected in a set 5a or module of heater elements, each heater element 5 in that set may subsequently be re-analyzed by the control unit 20 on an individual basis to specifically pinpoint the source of the defect.

Compared to the high voltage printing pulse, the energy density of the low voltage monitoring pulse is substantially lower. The monitoring voltage of the low voltage monitoring pulse may be equal to or less than 100 Volt, preferably between 10 and 60 Volt.

Also, the monitoring pulse time is generally equal to or longer than the printing pulse time. The monitoring pulse time can e.g. be at least a factor 10, or even at least a factor 100, longer than the printing pulse time. The monitoring voltage may be substantially constant over the monitoring pulse time, but other types of monitoring voltages may be equally suitable, like a random voltage signals, sinewave or block voltage signals.

The supplied monitoring pulse is used by the control unit 20 to determine an actual resistance of the resistive heater element 5, in particular by measuring the actual voltage and current through the resistive heater element 5 or through a set 5a of heater elements. The actual resistance is then compared to a reference, e.g. obtained from a database or determined in an earlier measurement.

When the control unit 20 determines that the actual resistance deviates from the reference by at least a delta, the control unit 20 generates an alert signal that is indicative of a faulty resistive heater element 5, or set 5a.

The reference, as well as the delta, can be determined in various ways. The reference can e.g. be obtained from an internal or remote database such as a lookup table. Optionally, the control unit 20 can be arranged for controlling the at least one resistive heater element 5 with the low voltage monitoring pulse in a startup phase of the impulse printing device prior to an initial print cycle, e.g. when the impulse device is switched on from an unpowered or paused state. The control unit 20 may in that case be arranged to determine the actual resistance of the resistive heater element(s) 5. The determined actual resistance can be compared to a reference obtained from a database, e.g. to verify that the device is functioning according to spec and that a print cycle can be started. Alternatively, or additionally, the control unit 20 may store the determined actual resistance as a baseline for a reference that can be used during subsequent monitoring cycles.

The control unit 20 may be arranged for logging, over multiple monitoring cycles, the determined actual resistance over time and for calculating the reference based on a moving average, e.g. a weighted average of the most recently determined actual resistance and an historic or fitted value of one or more older logged references. The historic reference can e.g. be obtained from a database and/or from a baseline measurement as described above. By taking the average value of the resistance over time, the monitoring cycle is less sensitive to outlier measurements which may misrepresent the actual health status of the resistive heater element(s). By using weights, the relative sensitivity, between recently measured actual resistance values and previously measured or obtained older resistance values, can be adapted. In this way, the monitoring cycle can be slower or faster to respond to momentary changes in the resistance of the heater element(s), and thus generate an alert signal earlier or later. Accordingly, the number of false positives and false negatives can be minimized.

Another way to improve the reliability of the monitoring cycles is by setting the delta as a percentage of the reference, rather than using a fixed delta, or a fixed threshold. By relating the delta to the reference, the monitoring cycle can account for gradual changes in performance of the resistive heater elements that are for example caused by normal wear, temperature dependency of the heater elements, or environmental conditions. The delta can e.g. be set between 1%-5% of the reference. Alternatively, or additionally, any factors that can influence the sensitivity of the monitoring cycle, like temperature dependency, can be taken into account by the control unit when performing the measurement, when establishing the reference, or when performing the comparison.

In some embodiments, the control unit is arranged for determining a first actual resistance of a first resistive heater element 5 and a second actual resistance of a second resistive heater element 5'. The first and second resistive heater elements 5, 5' can e.g. be located in close proximity or next to each other in an array, or may be located in different areas of the array. The control unit 20 may be arranged for comparing the first actual resistance to the second actual resistance, and for generating an alert signal in response to determining that the first and second actual resistances deviate from each other by at least a further threshold. In other words, the measured actual resistances of different resistive heater elements 5, 5' are compared to each other. This comparison can be performed in addition to the comparison with a reference as described above, or as an alternative. By comparing the measured resistance of one heater element 5 to the measured resistance of another heater element 5', any spatial effects in the array of heater elements can be identified and monitored.

To increase the reliability of the monitoring cycle, the control unit 20 can optionally be arranged for calculating a first moving average of the first actual resistance over a time period, and for calculating a second moving average of the second actual resistance over the same time period. Accordingly, the control unit 20 can further be arranged for comparing the first moving average to the second moving average, and for generating an alert signal in response to determining that the first and second moving averages deviate from each other by at least the further threshold, e.g. between 3-5% of the first or second moving average.

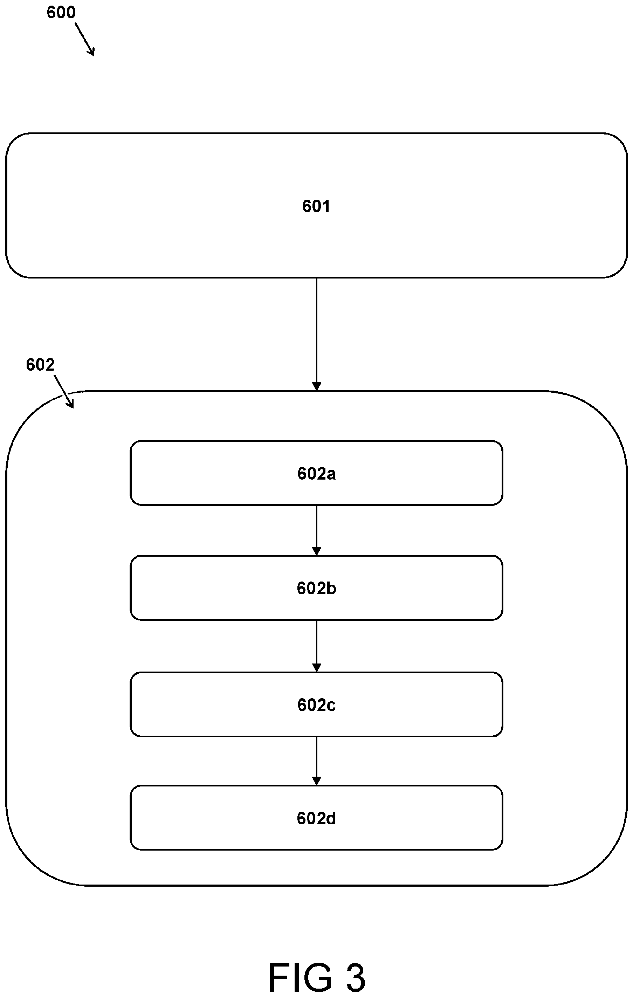

FIG. 3 represents a method 600, performed by the impulse printing device 1 described herein, for in-situ monitoring a health status of at least one resistive heater element of the impulse printing device. The method comprises performing a print cycle (step 601), by controlling the at least one resistive heater element with a high voltage printing pulse for rapidly evaporating a part of the substance at its contact surface, for therewith inducing a pressure that causes a transfer of a remainder of the patterned substance in a transfer direction towards an acceptor substrate.

The method 600 further comprises performing a monitoring cycle (step 602) which includes controlling 602a the at least one resistive heater element with a low voltage monitoring pulse, determining 602b an actual resistance of the at least one resistive heater element based on a measured voltage and current through the at least one resistive heater element, comparing 602c the actual resistance to a reference, and generating 602d an alert signal that is indicative of the at least one resistive heater element being faulty, in response to determining that the actual resistance deviates from the reference by at least a delta.

While FIG. 3 shows that the steps of performing a print cycle 601 and performing a monitoring cycle 602 are performed consecutively, e.g. a print cycle before a monitoring cycle, the invention is not limited to any particular sequence or relation between the print cycle and monitoring cycle. For example, the print cycle can be performed after the monitoring cycle. In preferred embodiments, the print cycle and monitoring cycle are performed alternatingly, in that every print cycle is followed and preceded by a monitoring cycle. Alternatively, or additionally, a monitoring cycle may be performed upon startup of the impulse printing device, before one or more print cycles are performed. Alternatively, or additionally, a monitoring cycle may be performed after a set of multiple print cycles is completed, and optionally the monitoring cycle is repeated every time a further set of multiple print cycles has been performed.

Alternatively or additionally, a monitoring cycle can be performed after a certain predefined time period has passed. For example, weekly or daily at a specific time, or after the impulse printing device has been active for a certain period of time. In other words, the execution of the monitoring cycle may be time based.

Regardless of whether an event based or time based approach is chosen, the monitoring cycle may be performed at regular or irregular intervals. Furthermore, the monitoring cycle may be performed automatically by the impulse printing device, or can be triggered by instructions or inputs of an operator.

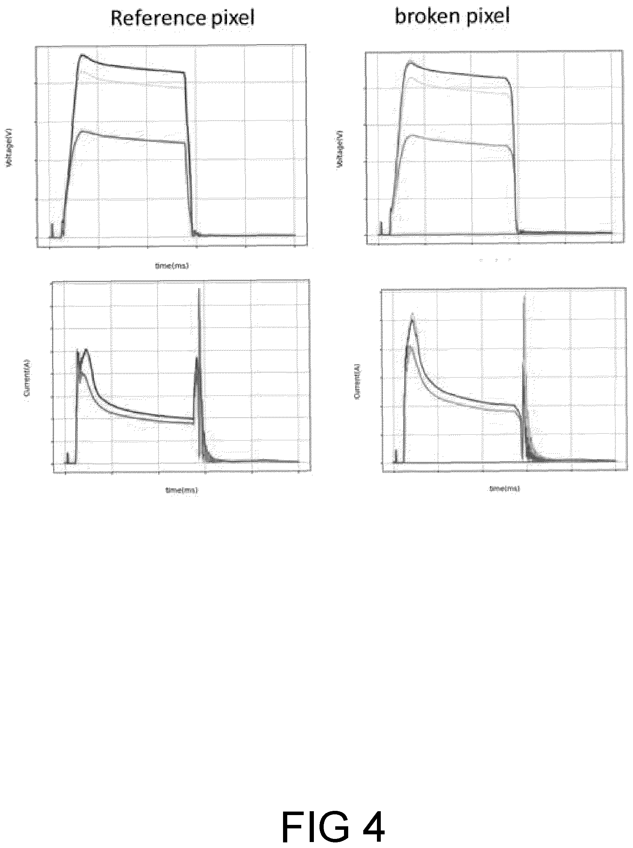

FIG. 4 provides a number of exemplary graphs that compare the measured output of a faulty resistive heater element, i.e. a broken pixel, to a reference pixel, e.g. a normal resistive heater element. The graphs show that the broken pixel produces a larger current than the reference pixel. When the difference between the current of the broken pixel and the current of the reference pixel exceeds a delta, the control unit of the impulse printing device generates an alert signal, e.g. to warn an operator or to deactivate the broken pixel such that it is not used in subsequent print cycles.

It will be clear to the skilled person that the invention is not limited to any specific embodiment herein described and that combinations or modifications are possible, in as far as these can be considered within the scope of the appended claims. In the claims, any reference signs shall not be construed as limiting the claim.

The terms 'comprising' and 'including' when used in this description or the appended claims should not be construed in an exclusive or exhaustive sense but rather in an inclusive sense. Thus expression as 'including' or 'comprising' as used herein does not exclude the presence of other elements, additional structure or additional acts or steps in addition to those listed. Furthermore, the words 'a' and 'an' shall not be construed as limited to 'only one', but instead are used to mean 'at least one', and do not exclude a plurality. Features that are not specifically or explicitly described or claimed may additionally be included in the structure of the invention without departing from its scope.

Expressions such as: "means for ..." should be read as: "component configured for ..." or "member constructed to ..." and should be construed to include equivalents for the structures disclosed. The use of expressions like: "critical", "preferred", "especially preferred" etc. is not intended to limit the invention. To the extent that structure, material, or acts are considered to be essential they are inexpressively indicated as such.

## Claims

1. An impulse printing device, comprising:
- a donor plate onto which a substance to be printed can be applied;
- at least one resistive heater element arranged for heating the applied substance at its contact surface with the donor plate; and
- a control unit arranged for controlling, in a print cycle, the at least one resistive heater element with a high voltage printing pulse for rapidly evaporating a part of the substance at its contact surface, for therewith inducing a pressure that causes a transfer of a remainder of the patterned substance in a transfer direction towards an acceptor substrate;
wherein the control unit is further arranged for monitoring a health status of the at least one heater element by:
o controlling the at least one resistive heater element with a low voltage monitoring pulse;
∘ determining an actual resistance of the at least one resistive heater element based on a measured voltage and current through the at least one resistive heater element;
∘ comparing the actual resistance to a reference;
∘ in response to determining that the actual resistance deviates from the reference by at least a delta, generating an alert signal that is indicative of a faulty resistive heater element.

2. The impulse printing device according to claim 1, wherein the at least one resistive heater element is part of an array of multiple resistive heater elements, and wherein the control unit is arranged for monitoring the health status for each resistive heater element of the array on a single element level.

3. The impulse printing device according to any preceding claim, wherein the control unit is arranged for monitoring the health status of the at least one resistive heater element between consecutive print cycles of the impulse printing device.

4. The impulse printing device according to any preceding claim, wherein, in a startup phase of the impulse printing device prior to an initial print cycle, the control unit is arranged for controlling the at least one resistive heater element with the low voltage monitoring pulse, and for storing the determined actual resistance of the at least one resistive heater element as a baseline of the reference.

5. The impulse printing device according to any preceding claim, wherein the control unit is arranged for logging the determined actual resistance over time, and for calculating the reference based on a weighted average of the most recently determined actual resistance and an historic or fitted value of one or more older logged references.

6. The impulse printing device according to any preceding claim, wherein the delta is between 1-5% of the reference.

7. The impulse printing device according to any preceding claim, wherein the at least one resistive heater element comprises a first resistive heater element and a second resistive heater element, wherein the control unit is arranged for determining a first actual resistance of the first resistive heater element and a second actual resistance of the second resistive heater element;
wherein the control unit is further arranged for comparing the first actual resistance to the second actual resistance, and for generating an alert signal in response to determining that the first and second actual resistances deviate from each other by at least a further threshold;
wherein preferably the further threshold is between 3-5% of the first or second actual resistance.

8. The impulse printing device according to claim 7, wherein the control unit is arranged for calculating a first moving average of the first actual resistance over a time period, and for calculating a second moving average of the second actual resistance of the time period;
wherein the control unit is further arranged for comparing the first moving average to the second moving average, and for generating an alert signal in response to determining that the first and second moving averages deviate from each other by at least the further threshold;
wherein preferably the further threshold is between 3-5% of the first or second moving average.

9. The impulse printing device according to any preceding claim, wherein, during the low power monitoring pulse, the control unit supplies a monitoring voltage to the at least one resistive heater element that is equal to or less than 100 Volt, preferably between 10 and 60 Volt.

10. The impulse printing device according to any preceding claim, wherein the high voltage printing pulse comprises a printing pulse time, wherein the low voltage monitoring pulse comprises a monitoring pulse time, and wherein the monitoring pulse time is equal to or longer than the printing pulse time.

11. The impulse printing device according to claim 10, wherein the monitoring pulse time is at least a factor 10, preferably at least a factor 100, longer than the printing pulse time.

12. The impulse printing device according to claim 10 or 11, wherein the monitoring pulse time is shorter than 10 milliseconds.

13. The impulse printing device according to any of claims 10-12, wherein the low voltage monitoring pulse comprises a monitoring voltage that is substantially constant over the monitoring pulse time.

14. A method, performed by the impulse printing device according to any preceding claim, for in-situ monitoring a health status of at least one resistive heater element of the impulse printing device, the method comprising:
- performing a print cycle, by controlling the at least one resistive heater element with a high voltage printing pulse for rapidly evaporating a part of the substance at its contact surface, for therewith inducing a pressure that causes a transfer of a remainder of the patterned substance in a transfer direction towards an acceptor substrate; and
- performing a monitoring cycle, by
∘ controlling the at least one resistive heater element with a low voltage monitoring pulse;
∘ determining an actual resistance of the at least one resistive heater element based on a measured voltage and current through the at least one resistive heater element;
∘ comparing the actual resistance to a reference; and
∘ in response to determining that the actual resistance deviates from the reference by at least a delta, generating an alert signal that is indicative of the at least one resistive heater element being faulty.

15. The method according to claim 14, wherein in response to generating the alert signal, the method comprises deactivating the faulty resistive heater element such that the faulty resistive heater element is not used during a subsequent print cycle.
